# EUROPÄISCHE PATENTSCHRIFT

(11) **EP 3 124 921 B1**
(45) Veröffentlichungstag und Bekanntmachung des Hinweises auf die Patenterteilung: **22.05.2019**
(21) Anmeldenummer: 15179014.4
(22) Anmeldetag: 30.07.2015
(51) Int. Cl.: G01D 5/26, H02S 40/44, G01D 5/347, H01L 31/0203

(54) **POSITIONSMESSEINRICHTUNG**
POSITION MEASURING DEVICE
DISPOSITIF DE MESURE DE POSITION

(43) Veröffentlichungstag der Anmeldung: 01.02.2017
(73) Patentinhaber: Dr. Johannes Heidenhain GmbH, 83301 Traunreut (DE)
(72) Erfinder: MAYER, Elmar, 83365 Nußdorf (DE)

(56) Entgegenhaltungen:
- EP-A1- 2 693 166
- DE-A1- 19 855 307
- DE-A1-102010 000 731

## Beschreibung

### GEBIET DER TECHNIK

Die vorliegende Erfindung betrifft eine Positionsmesseinrichtung nach dem Oberbegriff von Anspruch 1. Derartige Positionsmesseinrichtungen werden vorwiegend in der Automatisierungstechnik zum Messen von Wegen und/oder Winkeln eingesetzt.

### STAND DER TECHNIK

Positionsmesseinrichtungen sind insbesondere bei Werkzeugmaschinen und in der Automatisierungstechnik weit verbreitet. Sie dienen zur Bestimmung der Relativposition zweier zueinander beweglicher Objekte. Dabei unterscheidet man grundsätzlich zwischen Längen- und Winkelmessgeräten. Längenmessgeräte dienen beispielsweise zur Bestimmung der Relativposition zweier zueinander beweglicher Maschinenteile einer Werkzeugmaschine. Hierzu wird eine Maßverkörperung, beispielsweise in Form eines geraden Maßstabs, auf dem eine Messteilung angeordnet ist, mit dem einen und eine Abtasteinheit mit dem anderen der beiden Objekte verbunden, so dass durch Abtasten der Messteilung positionsabhängige Abtastsignale gewonnen werden, mit deren Hilfe sich das Ausmaß der Bewegung der beiden Objekte zueinander in der Bewegungsrichtung bestimmen lässt.

Winkelmessgeräte, auch unter der Bezeichnung Drehgeber bekannt, sind nach dem gleichen Prinzip aufgebaut. An die Stelle des Maßstabs tritt hier aber als Maßverkörperung eine kreisförmige Scheibe, auf der die Messteilung konzentrisch zum Drehpunkt angeordnet ist. Die Scheibe ist drehfest mit einer zu messenden Welle verbunden, während die Abtasteinheit hierzu fest montiert ist.

Die Messteilung kann eine oder mehrere Teilungsspuren umfassen, wobei inkrementale und absolut codierte Teilungsspuren unterschieden werden. Inkrementale Teilungsspuren bestehen aus regelmäßig angeordneten Teilungselementen, aus deren Abtastung bei gleichförmiger Relativbewegung zwischen Maßverkörperung und Abtasteinheit weitgehend sinusförmige Abtastsignale resultieren. Die Wegbestimmung basiert hier auf der Zählung der Signalperioden oder Bruchteilen von Signalperioden. Für eine absolute Wegbestimmung muss ein Referenzpunkt festgelegt werden, hierfür ist beispielsweise eine Referenzmarke vorgesehen, die ebenfalls von der Abtasteinheit erfasst wird. Aus den Abtastsignalen absolut codierter Teilungsspuren dagegen kann direkt die Absolutposition bestimmt werden, da diese in mehreren, nebeneinander angeordneten Teilungsspuren parallel (z.B. Gray-Code, BCD-Code,...), oder in einer Teilungsspur seriell (z.B. Kettencode, PRC) codiert ist. Darüber hinaus sind auch Messteilungen bekannt, die sowohl inkrementale, als auch absolute Teilungsspuren umfassen.

Ein weit verbreitetes Funktionsprinzip bei Positionsmesseinrichtungen ist die optische Abtastung. Dabei wird die Messteilung, die auf einer Maßverkörperung aufgebracht ist, mit gerichtetem Licht, das von einer Lichtquelle abgestrahlt wird, auf eine Anzahl von Fotodetektoren abgebildet. Die Maßverkörperung ist beweglich im Strahlengang des Lichts angeordnet und moduliert das Licht, wenn die Messteilung relativ zur Lichtquelle und den Fotodetektoren bewegt wird. Die Position, bzw. Positionsänderung wird durch Auswertung der Ausgangssignale der Fotodetektoren ermittelt. Die Messteilung kann aus Bereichen mit unterschiedlichen optischen Eigenschaften wie z.B. transparent/opak bestehen.

Die für die Abtastung erforderlichen Fotodetektoren sind meist gemeinsam auf einem Halbleiterchip angeordnet, der mittels Chip-On-Board-Technologie (COB) direkt auf eine Leiterplatte montiert wird. Hierbei wird der Chip mit seiner Rückseite erst auf die Leiterplatte geklebt und anschließend die Kontaktflächen auf seiner Oberseite mittels Drahtbonden an die Leiterplatte angeschlossen. Häufig sind neben den Fotodetektoren auch zumindest Teile der Auswerteelektronik für die Abtastsignale auf dem Halbleiterchip angeordnet.

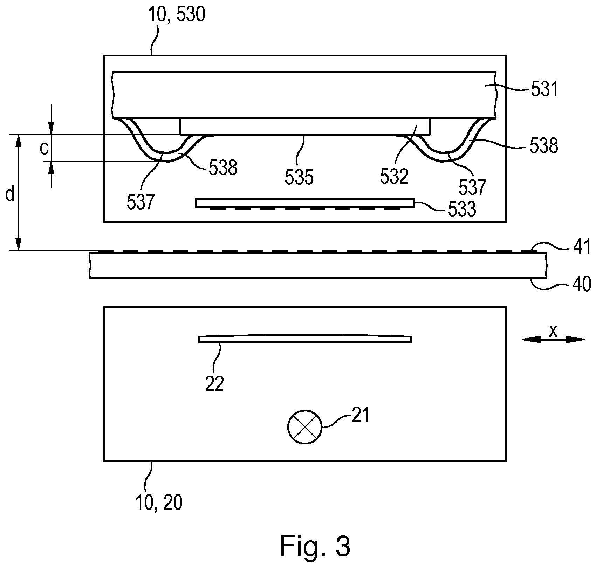

Figur 3 zeigt schematisch die für die Positionsmessung relevanten Komponenten einer aus dem Stand der Technik bekannten Positionsmesseinrichtung, nämlich eine Abtasteinheit 10 und eine Maßverkörperung 40, auf der eine Messteilung 41 angeordnet ist.

Die Abtasteinheit 10 und die Maßverkörperung 40 sind in einer Messrichtung X relativ zueinander beweglich angeordnet. Handelt es sich bei der Positionsmesseinrichtung beispielsweise um eine Einrichtung zur Längenmessung (lineare Positionsmesseinrichtung), so ist die Maßverkörperung 40 als gerader Maßstab ausgeführt, der an einem ersten Maschinenteil befestigt ist und auf dem in Messrichtung X eine Messteilung 41 angeordnet ist. Die Abtasteinheit 10 ist dann an einem zweiten Maschinenteil befestigt und zwar so, dass bei einer Bewegung des ersten Maschinenteils gegenüber dem zweiten Maschinenteil in der Messrichtung X die Abtasteinheit 10 am Maßstab entlang bewegt wird und dabei die Messteilung 41 abtastet. Aus der Abtastung resultieren Abtastsignale, aus denen in weiterer Verarbeitung Positionswerte generiert werden.

Bei rotatorischen Positionsmesseinrichtungen (Drehgebern oder Winkelmessgeräten) ist die Maßverkörperung 40 beispielsweise eine kreisrunde Scheibe, die drehfest mit einer Welle, deren Winkelposition gemessen werden soll, verbunden ist. Hier ist die Messteilung 41 konzentrisch zum Drehpunkt der Welle angeordnet. Die Abtasteinheit ist dagegen stationär befestigt und zwar so, dass bei einer Drehung der zu messenden Welle die Messteilung abtastbar ist und aus den Abtastsignalen wiederum Positionswerte, in diesem Fall Winkelwerte, generierbar sind.

Die Abtasteinheit 10 umfasst eine Beleuchtungseinheit 20 und eine Detektoreinheit 530. Das Funktionsprinzip, das der Positionsmesseinrichtung zugrunde liegt, ist das der optischen Durchlichtabtastung. Das bedeutet, die Messteilung 41 auf der Maßverkörperung 40 ist zwischen der Beleuchtungseinheit 20 und der Detektoreinheit 530 angeordnet. Die Beleuchtungseinheit 20 sendet Licht in Richtung der Messteilung 41 aus. Diese umfasst lichtdurchlässige (transparente) und lichtundurchlässige (opake) Bereiche, die das Licht der Beleuchtungseinheit 20 modulieren. Das modulierte Licht wird auf die Detektoreinheit 530 abgebildet, die hieraus Positionssignale generiert.

In der Praxis wird bei der optischen Durchlichtabtastung bevorzugt parallel ausgerichtetes Licht eingesetzt. Zur Erzeugung von parallel ausgerichtetem Licht kann die Beleuchtungseinheit 20 beispielsweise eine Lichtquelle 21 umfassen, die divergentes Licht aussendet, das von einem Kollimator 22 parallel ausgerichtet wird.

Die Maßverkörperung 40 besteht mit Vorteil aus einem transparenten Material, beispielsweise Glas. Die Messteilung 41 wird in diesem Fall durch opake Bereiche gebildet, beispielsweise durch Metall, das auf die Maßverkörperung aufgebracht wird. Besonders hierfür geeignet ist beispielsweise Chrom. Es sind aber auch Maßverkörperungen 40 bekannt, die aus einem opaken Material, beispielsweise einem Metall, bestehen. Hier kann die Messteilung 41 als Abfolge von Metallstegen und Durchbrüchen in der Maßverkörperung 40 ausgeführt sein.

Die Detektoreinheit 530 umfasst eine Leiterplatte 531, eine Sensoreinheit 532 und, insbesondere bei kleinen abzutastenden Teilungsperioden der Messteilung 41, eine Abtastplatte 533.

Die Leiterplatte 531 fungiert unter anderem als Träger für die Sensoreinheit 532, die die zentrale Komponente der Detektoreinheit 530 bildet. Auf der Leiterplatte 531 sind neben unterstützenden elektronischen Schaltungen für die Sensoreinheit 532 beispielsweise Ein-/Ausgabe-Schnittstellen in Form von Steckverbindern etc. angeordnet.

Die Sensoreinheit 532 ist als Halbleiterchip ausgeführt. Sie weist eine Vorderseite und eine Rückseite auf, wobei die der Leiterplatte 531 zugewandte Seite die Rückseite und die der Messteilung 41 zugewandte Seite die Vorderseite der Sensoreinheit 532 ist. Auf der Vorderseite der Sensoreinheit 532 ist eine Anzahl von Fotodetektoren 535 angeordnet, die zur Erzeugung von Positionssignalen durch Detektion des von der Messteilung 41 und ggf. der Abtastplatte 533 modulierten Lichts der Beleuchtungseinheit 20 dienen. Die Vorderseite der Sensoreinheit 532 ist zu der Ebene, in der sich die Messteilung 41 befindet, vorzugsweise parallel ausgerichtet. Neben den Fotodetektoren 535 umfasst die Sensoreinheit 532 mit Vorteil zusätzliche Komponenten zur Verarbeitung der Positionssignale, ggf. bis hin zur Bildung von Positionswerten aus den Positionssignalen. Darüber hinaus kann die Sensoreinheit eine Vielzahl weiterer Schaltungsblöcke umfassen, wie z.B. Fehlerkorrektur, Schaltungen zur Gewährleistung der Funktionssicherheit, sowie eine digitale Schnittstelle zur Kommunikation mit einer Folgeelektronik. Ein Halbleiterchip, der sowohl Fotodetektoren, als auch Komponenten zur Signalverarbeitung umfasst, wird als Opto-ASIC bezeichnet.

Die Rückseite der Sensoreinheit 532 ist mit der Leiterplatte 531 verbunden, wobei die Verbindung beispielsweise durch Kleben hergestellt wird. Für die elektrische Verbindung der Schaltungskomponenten der Sensoreinheit 532 mit der Leiterplatte 531 sind auf der Vorderseite der Sensoreinheit 532 und auf der der Sensoreinheit 532 zugewandten Seite der Leiterplatte 531 jeweils korrespondierende Kontaktflächen (nicht dargestellt) angeordnet, die in bekannter Weise durch Drahtbonden über Bonddrähte 537 miteinander verbunden werden. Die Bonddrähte 537 werden durch eine Vergussmasse 538 vor mechanischen Einflüssen geschützt.

Drahtbonden ist ein aufwändiger Fertigungsprozess, sowohl bezogen auf die Anschaffungskosten der erforderlichen Produktionsanlagen (Drahtbonder), als auch auf den zusätzlichen Zeitaufwand für das Drahtbonden, das Vergießen der Bonddrähte und das Aushärten der Vergussmasse.

Resultierend aus dieser Verbindungstechnik ergibt sich ein Damm um die Fotodetektoren, der sich um eine Höhe c bezogen auf die Vorderseite der Sensoreinheit 532 (also der Oberfläche des Halbleiterchips, auf der sich die Fotodetektoren befinden) abhebt. Die Höhe c beträgt bei herkömmlichen Fertigungsverfahren mindestens 0,5 mm. Unter Berücksichtigung von Fertigungstoleranzen, bedingt insbesondere durch Schwankungen in der Dicke der Vergussmasse 538, muss bei diesem Aufbau ein Abtastabstand d, definiert durch den Abstand der Vorderseite der Sensoreinheit 32 (der Oberfläche des Halbleiterchips, auf der sich die Fotodetektoren befinden) zur Oberfläche der Maßverkörperung 40 (im dargestellten Beispiel gleichzusetzen mit der Oberfläche der Messteilung 41), zwischen 0,55 mm und 0,7 mm eingehalten werden, um einen sicheren Betrieb gewährleisten zu können.

Die Abtastplatte 533 ist insbesondere bei der Abtastung von kleinen Teilungsperioden notwendig. Sie ist zwischen den Fotodetektoren 535 auf der Vorderseite der Sensoreinheit 532 und der Messteilung 41 angeordnet. Sie weist, ähnlich der Maßverkörperung 40, eine Teilungsstruktur auf, die die Abbildung der Messteilung 41 auf die Fotodetektoren 535 optimiert.

Die DE 198 55 307 A1 offenbart eine Abtasteinheit, bei der die Kontaktierung der Sensoreinheit durch Drahtbonden erfolgt. Über dem strahlungsempfindlichen Bereich ist zusätzlich ein Abdeckelement angeordnet, dessen Dicke den Kontaktierungsbereich noch übersteigt.

Es ist offensichtlich, dass sich bei dem optischen Abtastprinzip jegliche Schmutzablagerung im Strahlengang des Lichts nachteilig auf die Funktion auswirkt. Das gilt besonders für flüssige Verschmutzung. Diese tritt in Form von Flüssigkeitströpfchen auf, die beispielsweise aus Schmiermitteln, Kondenswasser, Kühlmittel, etc. bestehen. Sie reduziert nicht nur die auswertbare Lichtmenge, die auf die Fotodetektoren trifft, sondern streut auch noch das Licht, so dass es sich auf mehrere, nebeneinanderliegende Fotodetektoren verteilt.

Der Damm aus Vergussmasse 538 hat bezüglich Schmutzablagerungen negative Eigenschaften, da er, je nach Einbaulage, den Verbleib von Schmutzablagerungen innerhalb des Damms begünstigt.

Um Problemen durch Schmutzablagerungen vorzubeugen, wird bei der Konstruktion von Positionsmesseinrichtungen mit optischer Abtastung besonders darauf geachtet, dass die Einbringung von Schmutzpartikeln, in fester oder auch flüssiger Form, vermieden wird. Dies kann beispielsweise durch die Materialauswahl oder spezielle konstruktive Maßnahmen erfolgen.

Die vollständige Vermeidung einer Verschmutzung ist jedoch schwer möglich. Daher wird versucht, durch Schaffung von Redundanz bei der Abtastung oder durch aufwendige Signalverarbeitung der Abtastsignale den Einfluss von Schmutzpartikeln zu kompensieren.

Trotz all dieser Maßnahmen sind Schmutzpartikel, insbesondere in flüssiger Form, eine mögliche Ausfallursache optischer Positionsmesseinrichtungen.

### ZUSAMMENFASSUNG DER ERFINDUNG

Es ist daher Aufgabe der Erfindung, eine Positionsmesseinrichtung zu schaffen, die einfach zu Fertigen ist und eine geringe Verschmutzungsempfindlichkeit aufweist.

Diese Aufgabe wird gelöst durch eine Positionsmesseinrichtung nach Anspruch 1. Vorteilhafte Details einer derartigen Positionsmesseinrichtung ergeben sich aus den von Anspruch 1 abhängigen Ansprüchen.

Es wird eine Positionsmesseinrichtung vorgeschlagen, umfassend eine Maßverkörperung und eine Abtasteinheit, die in einer Messrichtung relativ zueinander beweglich angeordnet sind, wobei auf der Maßverkörperung eine Messteilung angeordnet ist, die von der Abtasteinheit zur Erzeugung von Positionssignalen abtastbar ist und die Abtasteinheit hierzu eine Beleuchtungseinheit und eine Detektoreinheit umfasst, wobei von der Beleuchtungseinheit Licht in Richtung der Messteilung aussendbar ist und von der Messteilung moduliertes Licht von der Detektoreinheit detektierbar ist und wobei die Detektoreinheit eine Leiterplatte und eine Sensoreinheit umfasst, die als Halbleiterchip ausgebildet ist. Die Erfindung ist dadurch gekennzeichnet, dass auf einer der Messteilung zugewandten Vorderseite der Sensoreinheit wenigstens zwei Fotodetektoren angeordnet sind und die elektrischen Anschlüsse der Sensoreinheit mittels metallischer Durchkontaktierungen zu Kontaktflächen auf deren Rückseite geführt sind und die Sensoreinheit über die Kontaktflächen an korrespondierende Kontaktflächen auf der Leiterplatte angeschlossen ist, wobei ein Abtastabstand zwischen der Vorderseite der Sensoreinheit und der Oberfläche der Messteilung weniger als 0,55 mm beträgt.

Weitere Vorteile sowie Einzelheiten der vorliegenden Erfindung ergeben sich aus der nachfolgenden Beschreibung anhand der Figuren.

### KURZE BESCHREIBUNG DER ZEICHNUNGEN

Es zeigt
- Figur 1: eine schematisch dargestellte erfindungsgemäße Positionsmesseinrichtung,
- Figur 2a: die durch ein Flüssigkeitströpfchen verursachte Streuung des Lichts bei großem Abtastabstand,
- Figur 2b: die durch ein Flüssigkeitströpfchen verursachte Streuung des Lichts bei kleinem Abtastabstand,
- Figur 3: eine schematisch dargestellte Positionsmesseinrichtung entsprechend dem Stand der Technik,
- Figur 4a: eine vorteilhafte Weiterbildung der Detektoreinheit aus Figur 1 und
- Figur 4b: eine Variante der Detektoreinheit aus Figur 4a.

### BESCHREIBUNG DER AUSFÜHRUNGSFORMEN

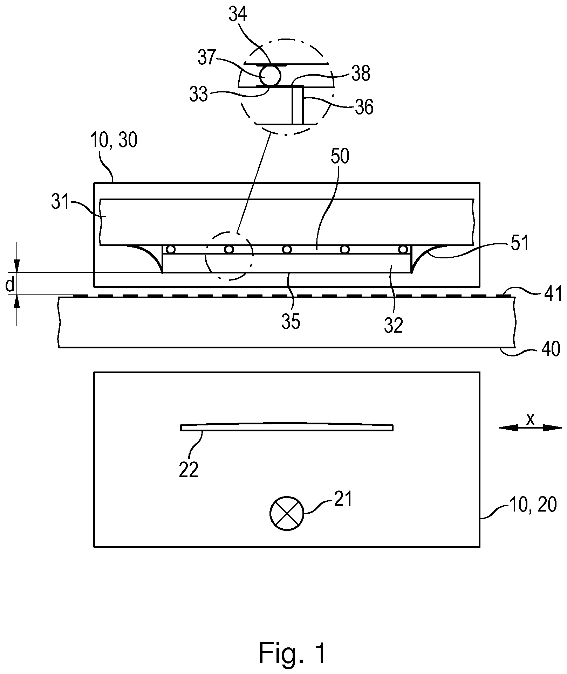

Figur 1 zeigt schematisch die für die Positionsmessung relevanten Komponenten einer erfindungsgemäßen Positionsmesseinrichtung. Der grundsätzliche Aufbau entspricht der einleitend anhand der Figur 3 beschriebenen Positionsmesseinrichtung, auf die hier ausdrücklich Bezug genommen wird. Komponenten, die bereits im Zusammenhang mit Figur 3 beschrieben wurden, tragen das gleiche Bezugszeichen.

Die Positionsmesseinrichtung umfasst eine Abtasteinheit 10 und eine Maßverkörperung 40, auf der eine Messteilung 41 angeordnet ist. Die Abtasteinheit 10 besteht aus einer aus dem Stand der Technik bekannten Beleuchtungseinheit 20 und aus einer erfindungsgemäß verbesserten Detektoreinheit 30.

Die entscheidende Verbesserung der Detektoreinheit 30 konnte dadurch erreicht werden, dass die Sensoreinheit 32, die als Halbleiterchip ausgeführt ist, nicht durch Drahtbonden elektrisch an die Leiterplatte 31 angeschlossen ist, sondern dass die Anschlüsse der elektrischen Schaltung im Halbleiterchip mittels Durchkontaktierungen 36 durch das Halbleitersubstrat, aus dem der Halbleiterchip besteht, zu Kontaktflächen 33 auf der Rückseite des Chips geführt sind und die elektrische Verbindung zu korrespondierenden Kontaktflächen 34 der Leiterplatte 31 über ein Lötverfahren hergestellt wird. Beispielsweise können zuerst auf die Kontaktflächen 33 des Halbleiterchips Metallkügelchen 37 aufgebracht werden, die anschließend durch Reflow-Löten mit den korrespondierenden Kontaktflächen 34 auf der Leiterplatte 31 verbunden werden. Der aufwändige Prozess des Drahtbondens wird also ersetzt durch einen Standard-Lötprozess. Das bedeutet, dass die Sensoreinheit 32 im Zuge der SMD-Bestückung zeitgleich mit den übrigen Komponenten auf der Leiterplatte 31 platziert und gelötet werden kann.

Die Vorderseite einer derart ausgeführten Sensoreinheit 32 weist eine ebene Oberfläche auf, die die Anlagerung von Schmutzpartikeln im Vergleich zu der aus dem Stand der Technik bekannten Sensoreinheit 532 erschwert.

Auf der Vorderseite der Sensoreinheit 32 sind wenigstens zwei Fotodetektoren 35 angeordnet, die das von der Messteilung 41 modulierte Licht der Beleuchtungseinheit 20 detektieren. Die tatsächliche Anzahl der Fotodetektoren 35 hängt von der Ausgestaltung der Messteilung 41 ab. Weist die Messteilung 41 mehr als eine Teilungsspur auf (beispielsweise eine inkrementale und, parallel dazu, eine oder mehrere absolut codierte Teilungsspuren), so ist eine geeignete Anzahl von Fotodetektoren 35 an den Teilungsspuren zugeordneten Positionen quer zur Messrichtung X angeordnet. Die so gewonnenen Positionssignale werden von einer Signalverarbeitungsschaltung, die mit Vorteil teilweise oder auch vollständig der Sensoreinheit 32 integriert ist, verarbeitet und weiter an eine Folgeelektronik (nicht dargestellt) ausgegeben. Wie einleitend bereits erwähnt, handelt es sich bei einem Halbleiterchip, der sowohl Fotodetektoren, als auch eine Signalverarbeitungselektronik umfasst, um einen Opto-ASIC.

Die Leiterplatte 31 kann aus glasfaserverstärktem Epoxidharz (Epoxy) bestehen, es können aber auch Keramikwerkstoffe wie beispielsweise Aluminiumoxid zum Einsatz kommen.

Die Durchkontaktierungen 36 sind meist vertikal angelegt und bestehen aus Metall, wodurch sie vergleichbare elektrische Eigenschaften aufweisen, wie die im Stand der Technik verwendeten Bonddrähte. Die Kontaktflächen 33 auf dem Halbleiterchip der Sensoreinheit 32 müssen nicht zwingend direkt über den Durchkontaktierungen 36 angeordnet sein. Vielmehr ist es möglich, dass sie versetzt zueinander angeordnet und über eine Leiterbahn 38 miteinander verbunden sind (Redistribution-Layer).

Basiert der Halbleiterchip, wie derzeit üblich, auf einem Silizium-Substrat, so spricht man auch von Silizium-Durchkontaktierungen oder Through-Silicon Vias (TSV). Halbleiterchips mit Silizium-Durchkontaktierungen werden derzeit vorwiegend bei Bildsensoren für die Digitalfotografie eingesetzt, weil durch die Verlegung der Kontaktflächen auf die Rückseite des Chips die nutzbare lichtempfindliche Fläche der Bildpunkte (Pixel) vergrößert werden kann. Außerdem kommen Halbleiter-Chips mit Silizium-Durchkontaktierungen zum Einsatz, um 3D-integrierte Schaltkreise (3D-IC) herzustellen, da diese Verbindungstechnik dazu geeignet ist, mehrere Chips übereinander zu stapeln und zu verbinden.

Im Hinblick auf die vorliegende Erfindung wurde erkannt, dass es die Verlegung der Kontaktflächen 33 von der Vorderseite der Sensoreinheit 32 auf die Rückseite der Sensoreinheit 32 ermöglicht, einen Abtastabstand d, der im Rahmen dieser Erfindung definiert ist durch den Abstand der Vorderseite der Sensoreinheit 32 (also der Oberfläche des Halbleiterchips, auf der sich die Fotodetektoren befinden) zur Oberfläche der Messteilung 41 (durch die geringe Dicke der Teilungsstriche im dargestellten Beispiel gleichzusetzen mit der Oberfläche der Maßverkörperung 40), gegenüber dem Stand der Technik wesentlich zu verringern. Durch den Wegfall der Bonddrähte 537 und der Vergussmasse 538 (also durch vollständige Eliminierung des Dammes mit der Höhe c) ist der Abtastabstand d nur noch von Aufbautoleranzen (z.B. Parallelität der Oberfläche der Sensoreinheit 32 zur Oberfläche der Maßverkörperung 40) und der mechanischen Führung der Abtasteinheit 10, bzw. der Sensoreinheit 32, gegenüber der Maßverkörperung 40 abhängig. Für den Abtastabstand d können somit in jedem Fall Werte kleiner als 0,55 mm gewählt werden, bei hinreichend genauem mechanischen Aufbau können sogar Werte für den Abtastabstand d von kleiner als 0,1 mm bis hinunter zu 0,03 mm erreicht werden.

Weitere elektronische Bauteile, die zusätzlich zur Sensoreinheit 32 benötigt werden, sowie Steckverbinder, etc., sind mit Vorteil auf der Rückseite der Leiterplatte 31 oder in Bereichen, in denen sich die Leiterplatte 31 und die Maßverkörperung 40 im montierten Zustand nicht überlappen, angeordnet.

Ein weiterer Vorteil, der sich durch den Einsatz einer erfindungsgemäßen Sensoreinheit 32 ergibt, ist es, dass bei kleinem Abtastabstand d auf eine Abtastplatte verzichtet werden kann. Dadurch verringert sich die Anzahl der Oberflächen im Strahlengang des zu detektierenden Lichts, deren optische Eigenschaften durch Verschmutzung beeinträchtigt werden können.

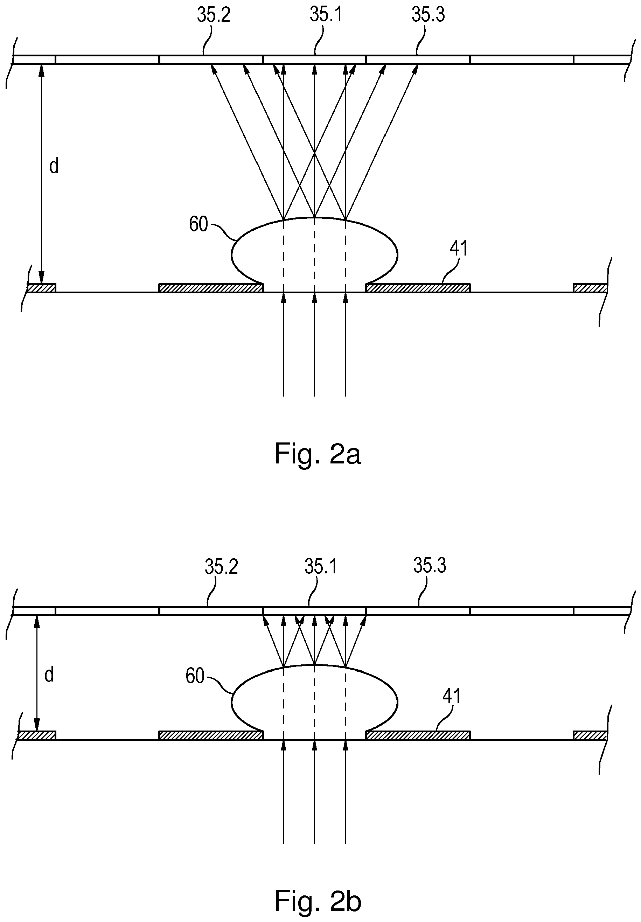

Die Figuren 2a und 2b zeigen den Einfluss des Abtastabstandes d auf die Verschmutzungsempfindlichkeit einer optischen Abtastung bei Verschmutzung durch Flüssigkeitströpfchen. Dabei wird angenommen, dass sich ein Flüssigkeitströpfchen 60 auf der Messteilung 41 befindet. Flüssigkeitströpfchen haben eine streuende Wirkung auf Lichtstrahlen. Daraus resultiert eine Unschärfe in der Abbildung der Messteilung 41 auf die Fotodetektoren 35 (dargestellt sind jeweils ein zentraler Fotodetektor 35.1 und zwei benachbarte Fotodetektoren 35.2, 35.3), die sich umso stärker auswirkt, je größer der Abtastabstand d wird.

Wie in Figur 2a dargestellt, führt ein großer Abtastabstand d dazu, dass ein beträchtlicher Teil des gestreuten Lichts auf die benachbarten Fotodetektoren 35.2, 35.3 fällt. Dies reduziert ein vom zentralen Fotodetektor 35.1 detektiertes Positionssignal, während die benachbarten Fotodetektoren 35.2, 35.3 fehlerhafte Positionssignale detektieren. Insgesamt wird die Zuverlässigkeit der Positionsmessung beeinträchtigt.

Eine Verringerung des Abtastabstands d, wie in Figur 2b gezeigt, führt dazu, dass trotz Streuung des Lichts ein großer Anteil des zu detektierenden Lichts auf den zentralen Fotodetektor 35.1 fällt und nur ein vernachlässigbarer Teil des gestreuten Lichts die benachbarten Fotodetektoren 35.2, 35.3 erreicht. Dies bewirkt eine signifikante Erhöhung der Zuverlässigkeit der Positionsmessung.

Ein kleiner Abtastabstand d hat darüber hinaus den Effekt, dass größere Flüssigkeitströpfchen zwischen der Vorderseite der Sensoreinheit 32 und der Oberfläche der Maßverkörperung 40 zusammengedrückt werden und so einen gleichmäßigen Flüssigkeitsfilm bilden, der eine Streuung des Lichts erheblich reduziert. Dieser Effekt wird bereits wirksam, wenn der Abtastabstand d auf weniger als 0,3 mm reduziert wird.

Wie in Figur 1 gezeigt, kann nach dem Lötprozess der verbleibende Hohlraum unter der Sensoreinheit 32 in einem Underfill-Prozess mit einem elastischen, temperaturbeständigen Kunststoffmaterial (Underfiller 50) ausgefüllt werden. Abgesehen von der Erhöhung der mechanischen Stabilität des Aufbaus und der Kompensation unterschiedlicher Wärmeausdehnungskoeffizienten der verwendeten Materialien wird so auch wirksam verhindert, dass Verschmutzungen, insbesondere Flüssigkeitströpfchen 60, in den Bereich der Lötverbindungen zwischen Sensoreinheit 32 und Leiterplatte 31 gelangen. Elektrische Ausfälle, hervorgerufen durch Fehlerströme aufgrund einer ohmschen Verbindung von Kontakten mit elektrisch leitfähigen Flüssigkeiten, sowie eine Beschädigung der Lötstellen durch Korrosion können so vermieden werden.

Weiter ist es vorteilhaft, um die Sensoreinheit 32 herum einen Seitenschutz 51 aus einem Kunststoffmaterial vorzusehen, der die Seitenflächen der Sensoreinheit 32 vor mechanischen Beschädigungen, beispielsweise durch größere Schmutzpartikel, schützt. Mit Vorteil schließt der Seitenschutz 51 mit der der Vorderseite zugehörigen Kante der Sensoreinheit 32 bündig ab.

Für Seitenschutz 51 und Underfiller 50 kann das gleiche Material eingesetzt werden.

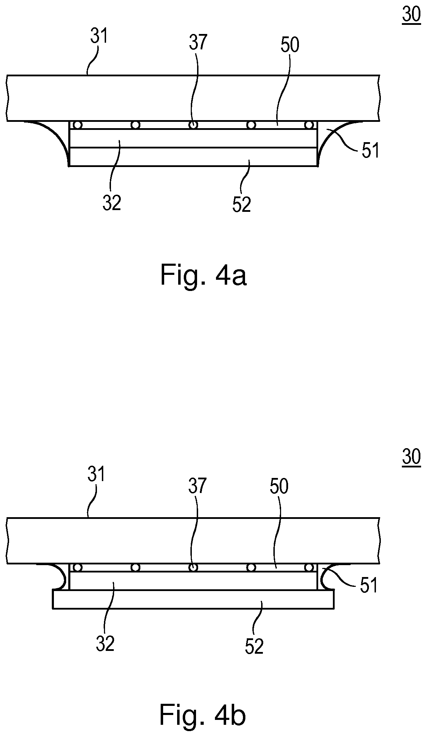

Figur 4a zeigt eine vorteilhafte Weiterbildung der Detektoreinheit 30 aus Figur 1, bei der die Vorderseite der Sensoreinheit 32 durch ein Schutzfenster 52 aus einem geeigneten transparenten Werkstoff (Glas, o.ä.) vor Beschädigungen geschützt ist. Die Verbindung zwischen der Sensoreinheit 32 und dem Schutzfenster 52 kann durch flächiges Kleben oder durch Ansprengen hergestellt sein.

Dieser Aufbau ist besonders einfach herstellbar, wenn bei der Herstellung eines Wafers mit einer Vielzahl von Sensoreinheiten 32 dieser bereits vor dem Aussägen der einzelnen Sensoreinheiten 32 mit einer Scheibe aus dem Werkstoff des Schutzfensters 52 verbunden wird. Durch das gemeinsame Aussägen weisen Sensoreinheit 32 und Schutzfenster 52 die gleiche Fläche auf. Der Seitenschutz 51 kann in diesem Fall soweit hochgezogen werden, dass er über die Seitenflächen der Sensoreinheit 32 hinaus ragt und die Seitenflächen des Schutzfensters 52 zumindest teilweise bedeckt. Auf diese Weise ist die Sensoreinheit 32 im fertig montierten Zustand der Detektoreinheit 30 allseitig vor mechanischen Beschädigungen geschützt.

Einen noch robusteren Aufbau der Detektoreinheit 30 erhält man, wenn, wie in Figur 4b gezeigt, die Fläche des Schutzfensters 52 größer ist als die Fläche der Sensoreinheit 32. In diesem Fall verbindet der Seitenschutz 51 die Leiterplatte 31 mit der der Sensoreinheit 32 zugewandten Rückseite des Schutzfensters 52. Auch dieser Aufbau ist einfach herstellbar, wenn bereits der Wafer mit den Sensoreinheiten 32 und die Scheibe aus dem Werkstoff des Schutzfensters 52 miteinander verbunden werden und vor dem Aussägen der Sensoreinheiten 32 die Bereiche zwischen den Sensoreinheiten 32 durch einen Ätzprozess bis zur Scheibe aus dem Werkstoff des Schutzfensters 52 freigeätzt werden.

Durch das Schutzfenster 52 erhöht sich der minimal erreichbare Abtastabstand d. Die Dicke des Schutzfensters kann aber in jedem Fall so gewählt werden, dass sie geringer als die durch das Drahtbonden vorgegebene Höhe c (ca. 0,5 mm) ist, so dass ein kleinerer Abtastabstand d als der im Stand der Technik vorgegebene Wert von 0,55 mm erreichbar ist. Mit Vorteil liegt die Dicke des Schutzfensters im Bereich zwischen 0,2 mm und 0,4 mm, wobei die untere Grenze durch erhöhten Aufwand in der Fertigung noch weiter verringert werden kann.

Sollte durch den größeren Abtastabstand d in Verbindung mit feinen Teilungsperioden der Messteilung 41 eine Abtastplatte erforderlich werden, so kann auf der der Messteilung 41 zugewandten Vorderseite des Schutzfensters 52 eine Teilungsstruktur angeordnet sein, die die Funktion einer Abtastplatte erfüllt, ohne die Anzahl der einer Verschmutzung ausgesetzten Oberflächen zu erhöhen.

Alternativ kann die Vorderseite der Sensoreinheit 32 durch Klarlack oder Klarverguss vor mechanischen Beschädigungen geschützt werden.

## Patentansprüche

1. Positionsmesseinrichtung, umfassend eine Maßverkörperung (40) und eine Abtasteinheit (10), die in einer Messrichtung (X) relativ zueinander beweglich angeordnet sind, wobei auf der Maßverkörperung (40) eine Messteilung (41) angeordnet ist, die von der Abtasteinheit (10) zur Erzeugung von Positionssignalen abtastbar ist und die Abtasteinheit (10) hierzu eine Beleuchtungseinheit (20) und eine Detektoreinheit (30) umfasst, wobei von der Beleuchtungseinheit (20) Licht in Richtung der Messteilung (41) aussendbar ist und von der Messteilung (41) moduliertes Licht von der Detektoreinheit (30) detektierbar ist und wobei die Detektoreinheit (30) eine Leiterplatte (31) und eine Sensoreinheit (32) umfasst, die als Halbleiterchip ausgebildet ist, wobei auf einer der Messteilung (41) zugewandten Vorderseite der Sensoreinheit (32) wenigstens zwei Fotodetektoren (35) angeordnet sind, **dadurch gekennzeichnet, dass** die elektrischen Anschlüsse der Sensoreinheit (32) mittels metallischer Durchkontaktierungen (36) zu Kontaktflächen (33) auf deren Rückseite geführt sind und die Sensoreinheit (32) über die Kontaktflächen (33) an korrespondierende Kontaktflächen (34) auf der Leiterplatte (31) angeschlossen ist, wobei ein Abtastabstand (d) zwischen der Vorderseite der Sensoreinheit (32) und der Oberfläche der Messteilung (41) weniger als 0,55 mm beträgt.

2. Positionsmesseinrichtung nach Anspruch 1, wobei der verbleibende Hohlraum zwischen Leiterplatte (31) und Sensoreinheit (32) mit einem Underfiller (50) ausgefüllt ist.

3. Positionsmesseinrichtung nach einem der Ansprüche 1 oder 2, wobei um die Sensoreinheit (32) herum ein Seitenschutz (51) vorgesehen ist.

4. Positionsmesseinrichtung nach einem der vorhergehenden Ansprüche, wobei die Vorderseite der Sensoreinheit (32) durch ein flächig aufgeklebtes oder angesprengtes Schutzfenster (52) vor mechanischen Beschädigungen geschützt ist.

5. Positionsmesseinrichtung nach Anspruch 4, wobei das Schutzfenster (52) die gleiche, oder eine größere Fläche aufweist, als die Sensoreinheit (32).

6. Positionsmesseinrichtung nach einem der Ansprüche 4 oder 5, wobei auf der der Messteilung (41) zugewandten Seite des Schutzfensters (52) eine Teilungsstruktur angeordnet ist.

7. Positionsmesseinrichtung nach einem der Ansprüche 1 bis 3, wobei die Vorderseite der Sensoreinheit (32) durch Klarlack oder Klarverguss vor mechanischen Beschädigungen geschützt ist.

8. Positionsmesseinrichtung nach einem der vorhergehenden Ansprüche, wobei ein Abtastabstand (d) zwischen der Vorderseite der Sensoreinheit (32) und der Oberfläche der Messteilung (41) weniger als 0,3 mm beträgt.

9. Positionsmesseinrichtung nach einem der vorhergehenden Ansprüche, wobei die Sensoreinheit (32) ein Opto-ASIC ist.

## Claims

1. Position measurement device, comprising a material measure (40) and a scanning unit (10), which are arranged to be movable in a measurement direction (X) relative to one another, wherein arranged on the material measure (40) is a measurement graduation (41) which is scannable by the scanning unit (10) for generating position signals and the scanning unit (10) to this end comprises an illumination unit (20) and a detector unit (30), wherein light is emittable by the illumination unit (20) in the direction of the measurement graduation (41) and light which has been modulated by the measurement graduation (41) is detectable by the detector unit (30), and wherein the detector unit (30) comprises a printed circuit board (31) and a sensor unit (32) which is embodied in the form of a semiconductor chip, wherein at least two photodetectors (35) are arranged on a front side of the sensor unit (32) facing the measurement graduation (41), **characterized in that** the electrical connections of the sensor unit (32) are guided by way of metallic vias (36) to contact surfaces (33) on the rear side thereof and the sensor unit (32) is connected by way of the contact surfaces (33) to corresponding contact surfaces (34) on the printed circuit board (31), wherein a scanning distance (d) between the front side of the sensor unit (32) and the surface of the measurement graduation (41) is less than 0.55 mm.

2. Position measurement device according to Claim 1, wherein the remaining hollow space between printed circuit board (31) and sensor unit (32) is filled with an underfill material (50).

3. Position measurement device according to either of Claims 1 and 2, wherein a side protection (51) is provided around the sensor unit (32).

4. Position measurement device according to one of the preceding claims, wherein the front side of the sensor unit (32) is protected against mechanical damage by a protective window (52) which is connected thereto areally using adhesive bonding or optical contact bonding.

5. Position measurement device according to Claim 4, wherein the protective window (52) has the same surface as, or a larger surface than, the sensor unit (32).

6. Position measurement device according to either of Claims 4 and 5, wherein a graduation structure is arranged on the side of the protective window (52) facing the measurement graduation (41).

7. Position measurement device according to one of Claims 1 to 3, wherein the front side of the sensor unit (32) is protected against mechanical damage by way of clear varnish or clear potting material.

8. Position measurement device according to one of the preceding claims, wherein a scanning distance (d) between the front side of the sensor unit (32) and the surface of the measurement graduation (41) is less than 0.3 mm.

9. Position measurement device according to one of the preceding claims, wherein the sensor unit (32) is an Opto-ASIC.

## Revendications

1. Dispositif de mesure de position comprenant un étalon de mesure (40) et une unité de balayage (10) qui sont disposés de manière mobile l'un par rapport à l'autre dans une direction de mesure (X), dans lequel une graduation de mesure (41), qui peut être balayée par l'unité de balayage (10) pour générer des signaux de position, est disposée sur l'étalon de mesure (40), et l'unité de balayage (10) comprend à cet effet une unité d'éclairage (20) et une unité de détection (30), dans lequel de la lumière peut être émise par l'unité d'éclairage (20) dans la direction de la graduation de mesure (41) et la lumière modulée par la graduation de mesure (41) peut être détectée par l'unité de détection (30), et dans lequel l'unité de détection (30) comprend une carte de circuit imprimé (31) et une unité de capteur (32) qui est réalisée sous la forme d'une puce à semiconducteur, dans lequel au moins deux photodétecteurs (35) sont disposés sur une face avant de l'unité de capteur (32) qui est tournée vers la graduation de mesure (41) ,
**caractérisé en ce que** les raccordements électriques de l'unité de capteur (32) sont guidés au moyen de trous traversants métalliques (36) vers des surfaces de contact (33) sur leur face arrière et **en ce que** l'unité de capteur (32) est raccordée par l'intermédiaire des surfaces de contact (33) à des surfaces de contact correspondantes (34) sur la carte de circuit imprimé (31), dans lequel une distance de balayage (d) entre la face avant de l'unité de capteur (32) et la surface de la graduation de mesure (41) est inférieure à 0,55 mm.

2. Dispositif de mesure de position selon la revendication 1, dans lequel la cavité restante entre la carte de circuit imprimé (31) et l'unité de capteur (32) est remplie par un matériau de remplissage (50)

3. Dispositif de mesure de position selon l'une des revendications 1 ou 2, dans lequel une protection latérale (51) est prévue autour de l'unité de capteur (32).

4. Dispositif de mesure de position selon l'une des revendications précédentes, dans lequel la face avant de l'unité de capteur (32) est protégée des dommages mécaniques par une fenêtre de protection (52) qui est collée ou déposée.

5. Dispositif de mesure de position selon la revendication 4, dans lequel la fenêtre de protection (52) présente une superficie identique ou supérieure à celle de l'unité de capteur (32).

6. Dispositif de mesure de position selon l'une des revendications 4 ou 5, dans lequel une structure de graduation est disposée sur la face de la fenêtre de protection (52) qui est tournée vers la graduation de mesure (41).

7. Dispositif de mesure de position selon l'une des revendications 1 à 3, dans lequel la face avant de l'unité de capteur (32) est protégée contre les dommages mécaniques par un vernis transparent ou un enrobage transparent.

8. Dispositif de mesure de position selon l'une des revendications précédentes, dans lequel une distance de balayage (d) entre la face avant de l'unité de capteur (32) et la surface de la graduation de mesure (41) de mesure est inférieure à 0,3 mm.

9. Dispositif de mesure de position selon l'une des revendications précédentes, dans lequel l'unité de capteur (32) est un circuit opto-ASIC.
